# EUROPEAN PATENT APPLICATION

(11) **EP 4 528 799 A1**
(43) Date of publication of application: **26.03.2025**
(21) Application number: 24201656.6
(22) Date of filing: 20.09.2024
(51) Int. Cl.: H01L 23/00, H01L 23/48, H01L 23/528

(54) **ELECTRONIC DEVICE**

(30) Priority: 25.09.2023 US 202363584924 P; 12.09.2024 US 202418883834
(71) Applicant: MediaTek Inc., Hsinchu City, 30078 (TW)
(72) Inventor: KUO, Kai-Lun, 30078 Hsinchu City (TW); TSAI, Kun-Ting, 30078 Hsinchu City (TW); KUO, Che-Hung, 30078 Hsinchu City (TW)
(74) Representative: Haseltine Lake Kempner LLP

(57) **Abstract**

An electronic device is provided. The electronic device includes a semiconductor die. The semiconductor die has a first region of a first functional cell close to the peripheral edge of the semiconductor die. The semiconductor die includes a semiconductor substrate, a first signal bump, and a first power bump. The first signal bump and the first power bump are disposed on opposite surfaces of the semiconductor substrate and electrically connected to the first functional cell. The first signal bump and the first power bump both overlap the first region.

## Description

This application claims the benefit of U.S. Provisional Application No. 63/584,924, filed September 25, 2023, the entirety of which is incorporated by reference herein.

### BACKGROUND OF THE INVENTION

### Field of the Invention

The present invention *relates* to an electronic device and, in particular, to the arrangement of bumps of a semiconductor die.

### Description of the Related Art

In order to ensure the continued miniaturization and multi-functionality of electronic products and communication devices, it is desired that integrated circuit (IC) devices be small in size, support multi-pin connection, operate at high speeds, and have high functionality. This will put pressure on semiconductor fabricators to develop high density interconnects for signal routing and power delivery.

Although existing IC devices have generally been adequate for their intended purposes, they have not been satisfactory in all respects. Thus, a novel electronic device is desirable to improve the voltage (IR) drop issue in high density interconnects.

### BRIEF SUMMARY OF THE INVENTION

An embodiment of the present invention provides an electronic device. The electronic device includes a semiconductor die. The semiconductor die has a first region of a first functional cell close to a peripheral edge of the semiconductor die. The semiconductor die includes a semiconductor substrate, a first signal bump and a first power bump. The first signal bump and the first power bump are disposed on opposite surfaces of the semiconductor substrate and electrically connected to the first functional cell. The first signal bump and the first power bump both overlap the first region.

An embodiment of the present invention provides an electronic device. The electronic device includes a semiconductor die. The semiconductor die has a peripheral edge region. The semiconductor die includes a first functional cell, a first-side interconnect structure and a second-side interconnect structure. The first-side interconnect structure is disposed above the first functional cell. The second-side interconnect structure is disposed below the first functional cell. The peripheral edge region includes a first signal bump and a first power bump. The first signal bump is disposed on the first-side interconnect structure and electrically connected to the first functional cell. The first power bump is disposed on the second-side interconnect structure and electrically connected to the first functional cell.

### BRIEF DESCRIPTION OF THE DRAWINGS

The present invention can be more fully understood by reading the subsequent detailed description and examples with references made to the accompanying drawings, wherein:
FIG. 1 is a schematic cross-sectional view of an electronic device in accordance with some embodiments of the disclosure;
FIG. 2 is an enlarged top view of a portion of the electronic device of FIG. 1 in accordance with some embodiments of the disclosure;
FIG. 3 is an enlarged bottom view of a portion of the electronic device of FIG. 1 in accordance with some embodiments of the disclosure;
FIG. 4 is a schematic cross-sectional view of an electronic device in accordance with some embodiments of the disclosure;
FIG. 5 is an enlarged top view of a portion of the electronic device of FIG. 4 in accordance with some embodiments of the disclosure;
FIG. 6 is an enlarged bottom view of a portion of the electronic device of FIG. 4 in accordance with some embodiments of the disclosure;
FIG. 7 is a schematic cross-sectional view of an electronic device in accordance with some embodiments of the disclosure;
FIG. 8 is an enlarged top view of a portion of the electronic device of FIG. 7 in accordance with some embodiments of the disclosure;
FIG. 9 is an enlarged bottom view of a portion of the electronic device of FIG. 7 in accordance with some embodiments of the disclosure;
FIG. 10 is a schematic cross-sectional view of an electronic device in accordance with some embodiments of the disclosure;
FIG. 11 is an enlarged top view of a portion of the electronic device of FIG. 10 in accordance with some embodiments of the disclosure; and
FIG. 12 is an enlarged bottom view of a portion of the electronic device of FIG. 10 in accordance with some embodiments of the disclosure.

### DETAILED DESCRIPTION OF THE INVENTION

The following description is made for the purpose of illustrating the general principles of the invention and should not be taken in a limiting sense. The scope of the invention is best determined by reference to the appended claims.

Advanced integrated circuit (IC) devices have become increasingly multifunctional and have been scaled down in size. Although the scaling down process generally increases production efficiency and lowers the associated costs, it has also increased the complexity of processing and manufacturing IC devices. For example, Fin Field-Effect Transistors (FinFETs) have been introduced to replace planar transistors. Among these FinFETs, gate-all-around (GAA) structures such as nanosheet or nanowire metal-oxide-semiconductor field-effect transistors (MOSFET) have been developed to possess excellent electrical characteristics, such as better power performance and area scaling compared to the current FinFET technologies. Furthermore, back-side power technology is used in gate-all-around (GAA) structures to decrease front-side routing, so as to decrease back end of line (BEOL) capacitance and IR drop, thereby improving performance of IC. Although existing integrated circuit (IC) devices are generally adequate, they are not satisfactory in every respect. For example, since the pitch of the input/output (I/O) cells is much smaller than the pitch of the I/O bumps of the I/O cell, it is a challenge to fulfill the input/output (I/O) bump arrangement requirements of the input/output (I/O) cell in the limited peripheral edge of a semiconductor die. Therefore, there is a need to further improve electronic devices to provide an improved design of the input/output (I/O) bumps.

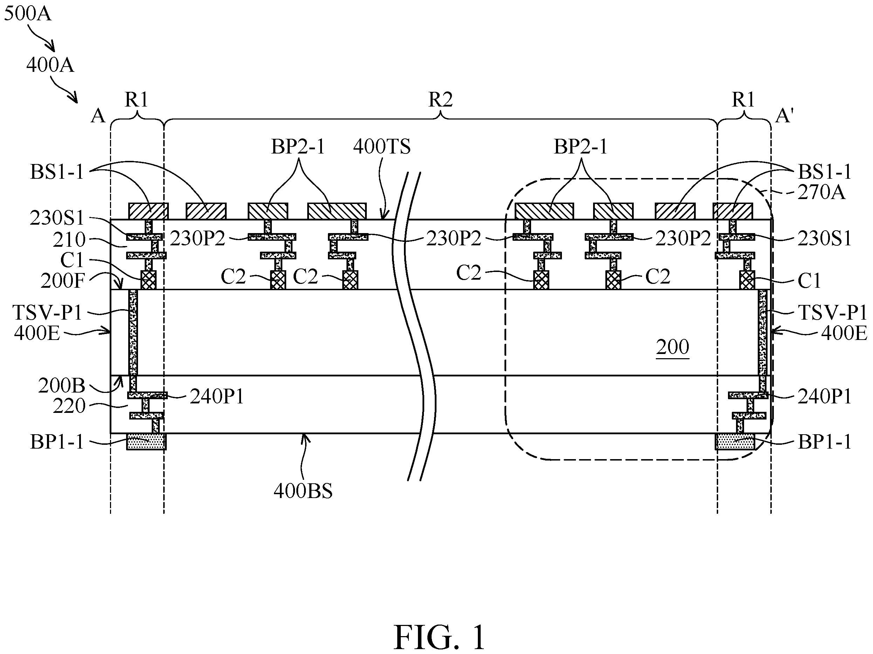

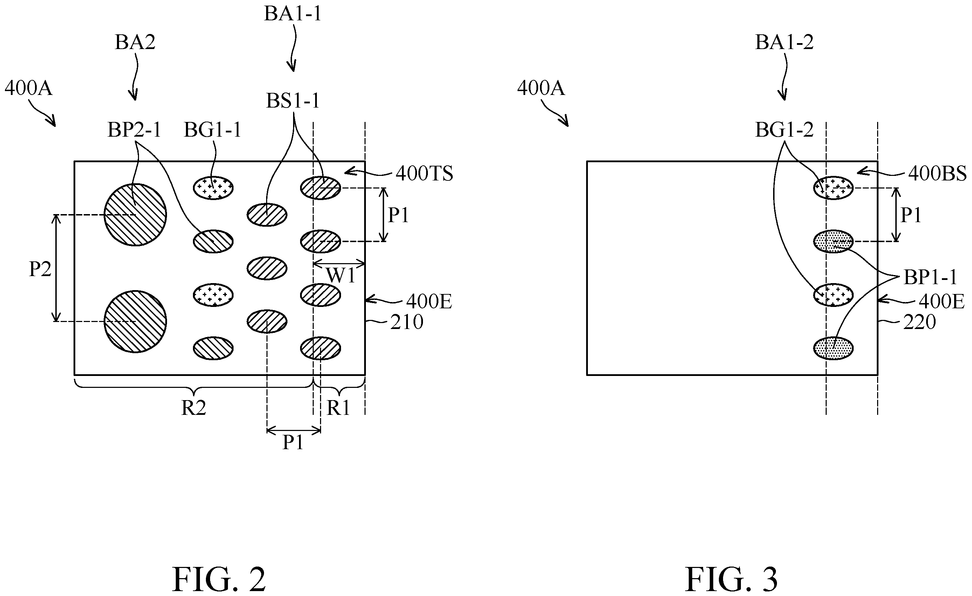

FIG. 1 is a schematic cross-sectional view of an electronic device 500A in accordance with some embodiments of the disclosure. FIG. 2 is an enlarged top view of a portion 270A of the electronic device 500A of FIG. 1 in accordance with some embodiments of the disclosure. FIG. 3 is an enlarged bottom view of a portion of the electronic device 500A of FIG. 1 in accordance with some embodiments of the disclosure. FIG. 1 is also a schematic cross-sectional view taken along the line A-A' crossing a peripheral edge region and a central region of a semiconductor die 400A. FIGS. 2 and 3 illustrate the arrangement of the bumps on the top and bottom surfaces and close to a peripheral edge 400E of the semiconductor die 400A.

The electronic device 500A includes the semiconductor die 400A. The semiconductor die 400A includes a top surface 400TS, a bottom surface 400BS and a peripheral edge (edge surface) 400E. In some embodiments, the semiconductor die 400A is applied in the back-side power technology. In addition, the semiconductor die 400A may be fabricated by the gate-all-around (GAA) processes. In some embodiments, the semiconductor die 400A may be mounted on a base (not shown) including a printed circuit board (PCB), a substrate or an interposer. In addition, another substrate (or an interposer) may be disposed on the semiconductor die 400A and opposite the base. In some embodiments, the semiconductor die 400A may be electrically connected to the base and the other substrate by bumps (e.g., microbumps, controlled collapse chip connection (C4) bumps, or a combination thereof) to form a wafer-level fan-out semiconductor package assembly. The bumps may be arranged on the top surface 400TS and the bottom surface 400BS of the semiconductor die 400A.

In some embodiments, the semiconductor die 400A has a first region R1 and a second region R2. The first region R1 is located close to a peripheral edge 400E of the semiconductor die 400A. The first region R1 is arranged continuous along the peripheral edge 400E. Therefore, the first region R1 is also called a peripheral edge region R1. In addition, the first region R1 may be provided for one or more first functional cells C1 disposed within. The second region R2 is arranged corresponding to the central portion of the semiconductor die 400A, also called the central region R2. The second region R2 is farther to the corresponding peripheral edge 400E than the first region R1. In addition, the first region R1 may surround the second region R2. In some embodiments, the second region R2 is provided for one or more second functional cells C2 disposed within.

In some embodiments, the second region R2 may be also provided for various functional cells including logic, memory, or processor cells disposed within. The first region R1 provides the electrical interface between the second region R2 and external circuitry.

In some embodiments, the semiconductor die 400A includes a semiconductor substrate 200, the first functional cell C1, the second functional cell C2, a front-side interconnect structure 210, a back-side interconnect structure 220, signal bumps BS1-1 and power bumps BP1-1, BP2-1.

The semiconductor substrate 200 has a front surface 200F and a back surface 200B. In some embodiments, the material of the semiconductor substrate 200 includes Si, SiP, SiGe, SiC, SiPC, Ge, SOI-Si, SOI-SiGe, III-VI material, or a combination thereof.

In this embodiment, the first functional cell C1 is formed on the front-side surface 200F of the semiconductor substrate 200. The first functional cell C1 may include an input/output (I/O) cell. The I/O cell is configured to transmit data and signals to and from external environment such as another chip, active and/or passive element(s) mounted on the same base (e.g., the printed circuit board (PCB)). In some embodiments, the second functional cell C2 is formed on the front-side surface 200F of the semiconductor substrate 200. The second functional cell C2 may include a center power cell. The center power cell may provide power to the core functional cells of the semiconductor die 400A and which transmit power to the peripheral power connections. In some embodiments, the first functional cell C1 and the second functional cell C2 may be composed of transistors, diodes, resistors, capacitors, and other active/passive devices, according to the requirements of design.

The front-side interconnect structure 210 is disposed on the front surface 200F of the semiconductor substrate 200. The back-side interconnect structure 220 is disposed on the back surface 200B of the semiconductor substrate 200 and opposite the front-side interconnect structure 210. The front-side interconnect structure 210 is separated from the back-side interconnect structure 220 by the semiconductor substrate 200. In this embodiment, the front-side interconnect structure 210 is formed covering and electrically connected to the first functional cell C1 and the second functional cell C2. The back-side interconnect structure 220 is electrically connected to the first functional cell C1.

In some embodiments, the front-side interconnect structure 210 may include multiple dielectric layers and conductive routings (including signal routings, power routings and ground routings) formed in the multiple dielectric layers. The conductive routings including conductive lines and vias (not shown) may be formed of copper or copper alloys, and may be formed using one or more damascene processes. The dielectric layers may include inter-layer dielectric (ILD) layers and inter-metal dielectric (IMD) layers.

In some embodiments, the front-side interconnect structure 210 may include signal routings (e.g., signal routings 230S1) and ground routings (not shown). The signal routings are configured to transmit data signals, control signals, and other user signals. The ground routings ground routings for grounding of the semiconductor die 400A. In some other embodiments, the front-side interconnect structure 260 may further include power routings (e.g., power routings 230P2). The power routings may include positive power supply voltage VDD, ground power supply voltage VSS, overdriven voltage signals (e.g., signals greater than VDD), negative power supply voltage signals, and other power supply voltage signals.

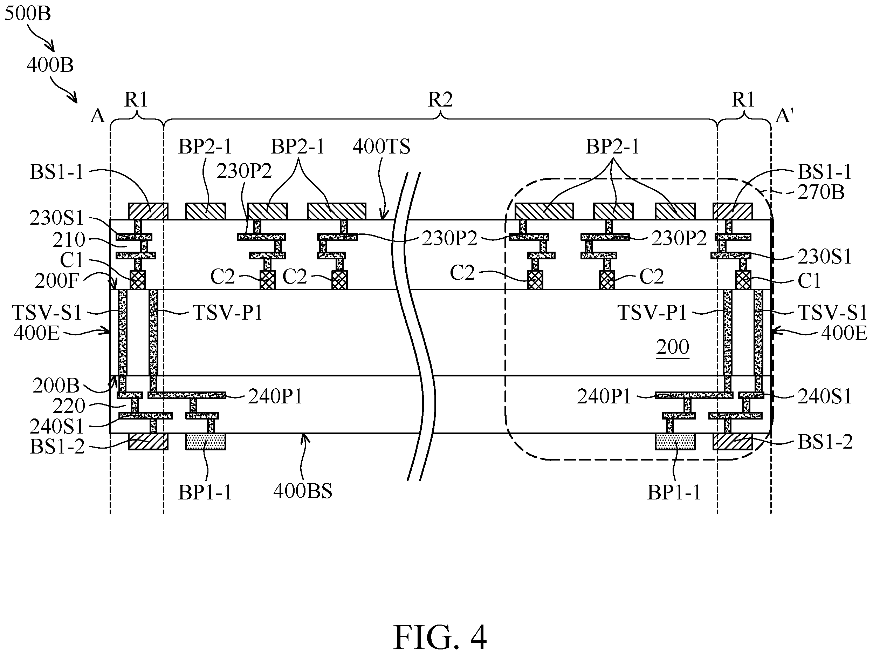

In some embodiments, the back-side interconnect structure 220 may be similar to the front-side interconnect structure 210 and includes multiple dielectric layers and conductive routings (including signal routings, power routings and ground routings) formed in the multiple dielectric layers. The number of dielectric layers in the front-side interconnect structure 210 and the back-side interconnect structure 220 may be the same or may be different. In some embodiments, the back-side interconnect structure 220 may include power routings (e.g., a power routing 240P1) and ground routings (not shown). In some other embodiments, the back-side interconnect structure 220 may further include signal routings (e.g., a signal routing 240S1 show in FIG. 4).

In some embodiments, the conductive routings in the back-side interconnect structure 220 is electrically connected to the first functional cell C1 by one or more through-substrate vias (TSV) passing through the semiconductor substrate 200. For example, the power routing 240P1 is electrically connected to the first functional cell C1 by a through-substrate via TSV-P1. The through-substrate via TSV-P1 may have a first end that terminates at the front surface 200F and connected to the corresponding terminal of the first functional cell C1. The through-substrate via TSV-P1 may have a second end that terminates at the back surface 200F of the semiconductor substrate 200 and connected to the power routing 240P1.

In some embodiments, the semiconductor die 200 includes signal bumps BS1-1, power bumps BP1-1 and ground bumps BG1-1, BG1-2 electrically connected to the first functional cell C1.

In some embodiments, the number of signal bumps BS1-1, power bumps BP1-1 and ground bumps BG1-1, BG 1-2 corresponding to the first functional cell C1 may have specific signal to power/ground ratio. For example, when the first functional cell C1 is an I/O cell, signal to power/ground ratio of the first functional cell C1 may be 4:1. For each VDD and VSS power signal pair, four signal bumps are provided, and the total number of signal, power and ground bumps is 6.

For example, the signal bumps BS1-1 and the ground bumps BG1-1 are disposed on the outermost layer of the front-side interconnect structure 210. In other words, the signal bumps BS1-1 and the ground bumps BG1-1 are disposed on the top surface 400TS of the semiconductor die 400A. The signal bumps BS1-1 are electrically connected to the signal routing 230S1 of the front-side interconnect structure 210. The ground bumps BG1-1 are electrically connected to the ground routing (not shown) of the front-side interconnect structure 210. The signal bumps BS1-1 and the ground bumps BG1-1 are electrically connected to corresponding bump pads (not shown) of the front-side interconnect structure 210.

In some embodiments, the power bumps BP1-1 and the ground bumps BG1-2 are disposed on the outermost layer of the back-side interconnect structure 220. In other words, the power bumps BP1-1 and the ground bumps BG1-2 are disposed on the bottom surface 400BS of the semiconductor die 400A. The power bumps BP1-1 are electrically connected to the power routing 240P1 of the back-side interconnect structure 220. The ground bumps BG1-2 are electrically connected to the ground routing (not shown) of the back-side interconnect structure 220. The power bumps BP1-1 and the ground bumps BG1-2 are electrically connected to corresponding bump pads (not shown) of the back-side interconnect structure 220.

In some embodiments, the signal bumps BS1-1 are separated from the power bumps BP1-1 and the ground bumps BG1-2 by the semiconductor substrate 200, the front-side interconnect structure 210 and the back-side interconnect structure 220. In addition, the ground bumps BG1-1 are separated from the power bumps BP1-1 and the ground bumps BG1-2 by the semiconductor substrate 200, the front-side interconnect structure 210 and the back-side interconnect structure 220.

In some embodiments, the signal bumps BS1-1 and the ground bumps BG1-1 on the front-side interconnect structure 210 may arranged as a bump array BA1-1 having a single row or multi rows. The bump array BA1-1 may at least overlap the first region R1.

The signal bumps BS1-1 and the ground bumps BG1-1 of the bump array BA1-1 has a bump pitch P1 (in row and column directions). In some embodiments, the pitch P1 is greater than a width W1 of the first region R1. In addition, the width W1 is measured along a direction substantially perpendicular to the corresponding peripheral edge 400E of the semiconductor die 400A.

In the bump array BA1-1, the signal bumps BS1-1 may be arranged close to the peripheral edge 400E than the ground bumps BG1-1. For example, the signal bumps BS1-1 may be arranged in a single row overlapping the first region R1 only. Alternatively, the signal bumps BS1-1 may be arranged in multi rows overlapping the first region R1 and the second region R2, depending on the total number of the signal bumps BS1-1 and the dimension of the first region R1. In addition, the ground bumps BG1-1 may be arranged overlapping the second region R2.

In some embodiments, the power bumps BP1-1 and the ground bumps BG1-2 on the back-side interconnect structure 220 may arranged as a bump array BA1-2 overlapping the first region R1. In some embodiments, the bump array BA1-1 and the bump array BA1-2 have the same bump pitch P1.

Because the signal to power/ground ratio, the number of power bumps and ground bumps is less than the number of power bumps corresponding to the same first functional cell C1, the power bumps BP1-1 and the ground bumps BG1-2 on the back-side interconnect structure 220 may arranged as the bump array BA1-2 having single-row substantially along and overlapping the first region R1. The bump array BA1-2 may not overlap the second region R2. In the bump array BA1-2, the power bumps BP1-1 may be arranged alternately with the ground bumps BG1-2. When the first functional cell C1 is an I/O cell, the bump arrays BA1-1 and BA1-2 are also called an I/O bump arrays BA1-1 and BA1-2.

In the first region R1, the power bumps BP1-1 and some of the signal bumps BS1-1 disposed on opposite surfaces of the semiconductor substrate 200. The ground bumps BG1-2 and some of the signal bumps BS1-1 disposed on opposite surfaces of the semiconductor substrate 200. More specifically, the power bumps BP1-1 are disposed on the back surface 200B of the semiconductor substrate 200. Some of the signal bumps BS1-1 are disposed on the front surface 200F of the semiconductor substrate 200. In addition, the ground bumps BG1-2 are disposed on the back surface 200B of the semiconductor substrate 200.

The semiconductor die 200 further includes power bumps BP2-1 electrically connected to the second functional cell C2. For example, the power bumps BP2-1 are disposed on the outermost layer of the front-side interconnect structure 210. In other words, the power bumps BP2-1 are disposed on the top surface 400TS of the semiconductor substrate 200. The power bumps BP2-1 are electrically connected to the power routings 230P2 of the front-side interconnect structure 210. The power bumps BP2-1 are electrically connected to corresponding bump pads (not shown) of the front-side interconnect structure 210.

In some embodiments, the power bumps BP2-1 on the front-side interconnect structure 210 may be arranged as a bump array BA2 having multi rows. The bump array BA2 may overlap the second region R2. In addition, the power bumps BP2-1 may be arranged alternately with the ground bumps BG1-1 and/or the signal bumps BS1-1 overlapping the second region R2.

In some embodiments, the power bumps BP2-1 may be arranged with various shapes, sizes and pitches in the top view. The shape, size and pitch of the power bumps BP2-1 arranged alternately with the ground bumps BG1-1 and/or the signal bumps BS1-1 may be the same as the shape, size and pitch of the ground bumps BG 1-1 and/or the signal bumps BS1-1. For example, the power bumps BP2-1 arranged alternately with the ground bumps BG1-1 and/or the signal bumps BS1-1 may have an oval shape with a smaller size and pitch (e.g., the pitch P1). The power bumps BP2-1 not arranged alternately with the ground bumps BG1-1 and/or the signal bumps BS1-1 may have a circular shape with a larger size and pitch (e.g., a pitch P2).

In some embodiments, the power bumps BP1-1 and the power bumps BP2-1 are disposed on opposite surface of the semiconductor substrate 200. For example, the power bumps BP1-1 are disposed on the front-side surface 200F of the semiconductor substrate 200, and the power bumps BP2-1 are disposed on the back surface 200B of the semiconductor substrate 200. When the second functional cell C2 is a center power cell, the bump array BA2 is also called a center power bump array BA2.

In some embodiments, the bump array BA1-1, the bump array BA1-2 and the bump array BA2 have the same bump pitch P1.

In the electronic device 500A, the semiconductor substrate 200 is fabricated using back-side power technology to decrease front-side routing. The power bumps BP1-1 electrically connected to the first functional cell C1 arranged in the peripheral edge region R1 may move onto the back surface 200B of the semiconductor substrate 200 accordingly. The bumps array BA1-1 (the I/O bumps array BA1-1) for the first functional cell C1 (e.g. the I/O cell) may have reduced number of rows. The conductive routings of the first functional cell C1 in the front-side interconnect structure 210 can be reduced, thereby improving IR drop issue. In addition, the area of the front-side interconnect structure 210 in the central region R2 originally occupied by the bumps (the I/O bumps) electrically connected to the first functional cell C1 may be released for putting more power bumps BP2-1 (and the corresponding power routings and bump pads of the front-side interconnect structure 210) for the second functional cell C2 (e.g. the center power cell). The bump array BA2 (the center power bump array BA2) may have more rows. The performance of the second functional cell C2 can be improved.

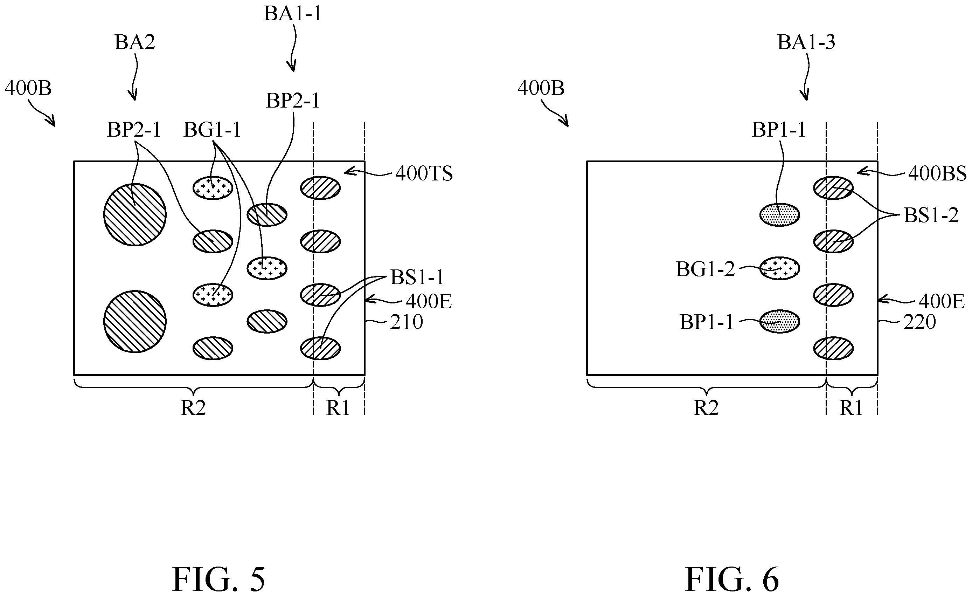

FIG. 4 is a schematic cross-sectional view of an electronic device 500B in accordance with some embodiments of the disclosure. FIG. 5 is an enlarged top view of a portion 270B of the electronic device 500B of FIG. 4 in accordance with some embodiments of the disclosure. FIG. 6 is an enlarged bottom view of a portion of the electronic device 500B of FIG. 4 in accordance with some embodiments of the disclosure. FIG. 4 is also a schematic cross-sectional view taken along the line A-A' crossing the peripheral edge region R1 and the central region R2 of a semiconductor die 400B. FIGS. 5 and 6 illustrate the arrangement of the bumps on the top and bottom surfaces 400TS, 400BS and close to the peripheral edge 400E of the semiconductor die 400B. Elements of the embodiments hereinafter, that are the same or similar as those previously described with reference to FIGS. 1, 2 and 3, are not repeated for brevity.

As shown in FIGS. 1-6, the difference between the electronic device 500A and the electronic device 500B at least includes that the semiconductor die 400B of the electronic device 500B further includes signal bumps BS1-2 and signal routings 240S1 arranged on the back surface 200B of the semiconductor substrate 200 and electrically connected to the first functional cell C1.

In some embodiments, the signal routing 240S1 is electrically connected to the first functional cell C1 by a through-substrate via TSV-S1. Similarly, the through-substrate via TSV-S1 may have a first end that terminates at the front surface 200F and connected to the corresponding terminal of the first functional cell C 1 The through-substrate via TSV-S1 may have a second end that terminates at the back surface 200F of the semiconductor substrate 200 and connected to the signal routing 240S1.

The signal bumps BS1-2 are disposed on the outermost layer of the back-side interconnect structure 220. In other words, the signal bumps BS1-2 are disposed on the bottom surface 400BS of the semiconductor die 400B. The signal bumps BS1-2 are electrically connected to signal routings 240S1 of the back-side interconnect structure 220. The signal bumps BS1-2 are electrically connected to corresponding bump pads (not shown) of the back-side interconnect structure 220.

In some embodiments, the signal bumps BS1-2 are disposed overlapping the first region R1. The signal bumps BS1-1 and the signal bumps BS1-2 are disposed on opposite surfaces of the semiconductor substrate 200. More specifically, the signal bumps BS1-1 are disposed on the front surface 200F of the semiconductor substrate 200, and the signal bump BS1-2 are disposed on the back surface 200B of the semiconductor substrate 200.

In the semiconductor die 400B, since the signal bumps (including the signal bumps BS1-1 and BS1-2) are disposed on opposite surfaces of the semiconductor substrate 200, the bump array BA1-1 may have reduced number of the signal bumps BS1-1. For example, the signal bumps BS1-1 of the semiconductor die 400B may be arranged in a single row overlapping the first region R1 only. In addition, the ground bumps BG 1-1 of the semiconductor die 400B may be arranged overlapping the second region R2.

In some embodiments, the signal bump BS1-2, the power bumps BP1-1 and the ground bumps BG1-2 on the back-side interconnect structure 220 may arranged as a bump array BA1-3 having a single row or multi rows. The bump array BA1-3 may at least overlap the first region R1. For example, the bump array BA1-3 may have multi rows overlapping the first region R1 and occupying a portion of the second region R2. Because there is no bumps electrically connected to the second functional cell C2 disposed on the back-side interconnect structure 220 in the second region R2, the occupied portion of the second region R2 on the back surface 200B of the substrate 200 will not affect the arrangement of the bumps (e.g., the power bumps BP2-1) and the performance of the second functional cell C2 (e.g., the center power cell).

In some embodiments, the bump array BA1-1, the bump array BA 1-2, the bump array BA2 and the bump array BA1-3 have the same bump pitch P1.

Compared with electronic device 500A, the electronic device 500B further moves some signal bumps electrically connected to the first functional cell C1 onto the back surface 200B of the semiconductor substrate 200. Therefore, the electronic device 500B may further reduce the number of rows of the bump array BA1-1. More area of the front-side interconnect structure 210 in the central region R2 originally occupied by the bump array BA1-1 may be released for putting more power bumps (and the corresponding power routings and bump pads of the front-side interconnect structure 210) for the second functional cell C2. The performance of the second functional cell C2 can be further improved.

In some embodiments, the first functional cells (e.g., the I/O cell) arranged in the peripheral edge region R1 may be formed on the front surface 200F and the back surface 200B of the semiconductor die 200. For example, some first functional cells and the front-side interconnect structure 210 may be formed on the front surface 200F of the semiconductor substrate 200 in sequence. Next, the semiconductor substrate 200 may be flipped upside down. Some other first functional cells and the back-side interconnect structure 220 may be formed on the back surface 200B of the semiconductor die 200 in sequence. Therefore, the signal bumps, power bumps and ground bumps for the first functional cells may be disposed on opposite surfaces of the semiconductor substrate 200. The bump array (e.g., the I/O bump array) for the first functional cells on each of the opposite surfaces of the semiconductor substrate 200 may have reduced number of rows. The bumps for the first functional cells on the front surface 200F of the semiconductor substrate 200 may be arranged to merely overlapping the peripheral edge region R1 in order to minimize the occupied area of the front-side interconnect structure 210 in the second region R2. Therefore, more bumps (e.g., the power bumps BP2-1) for the second functional cell C2 (e.g., the center power cell) can be arranged on the front surface 200F of the semiconductor substrate 200 in the second region R2. The performance of the second functional cell C2 (e.g., the center power cell) can be improved.

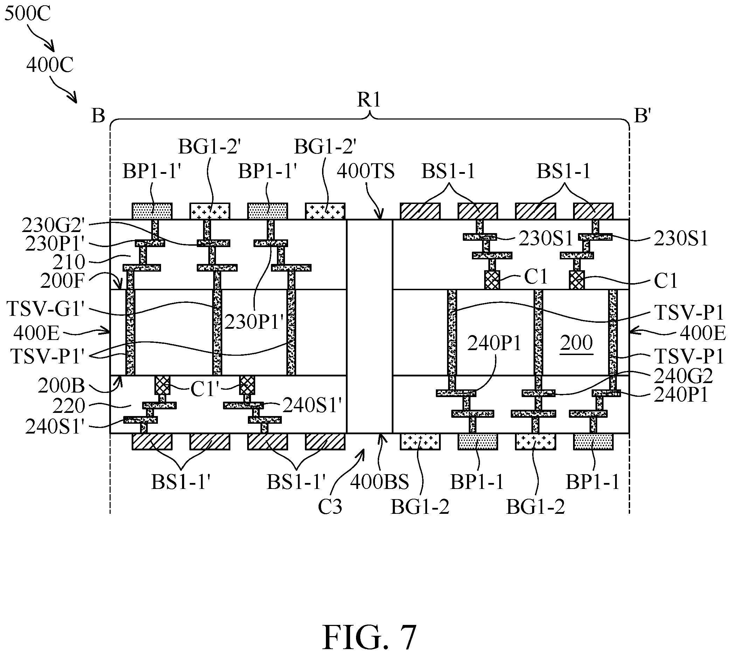

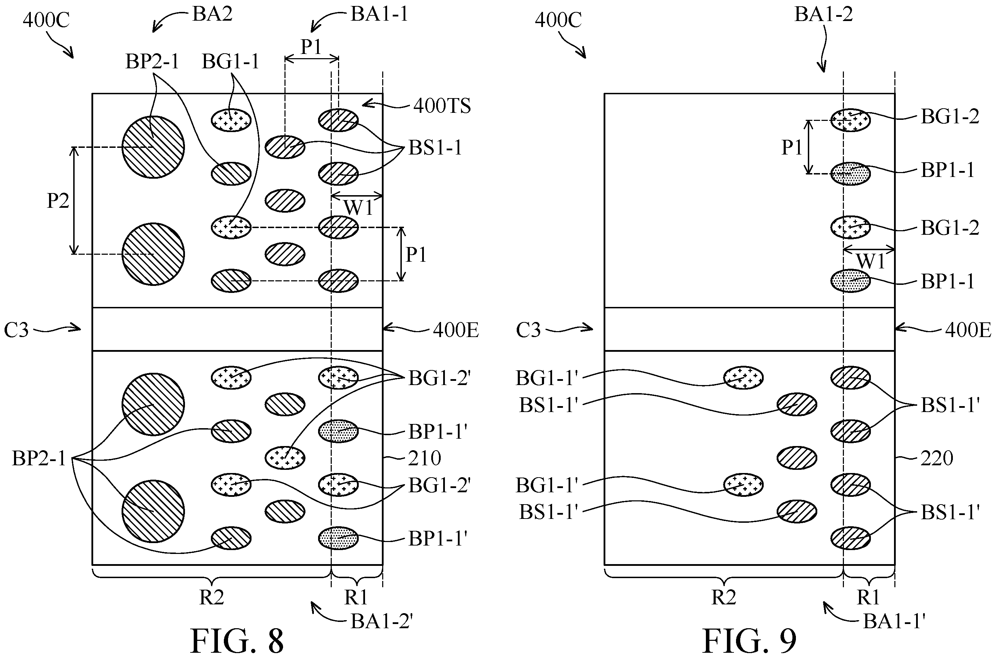

FIG. 7 is a schematic cross-sectional view of an electronic device 500C in accordance with some embodiments of the disclosure. FIG. 8 is an enlarged top view of a portion of the electronic device 500C of FIG. 7 in accordance with some embodiments of the disclosure. FIG. 9 is an enlarged bottom view of a portion of the electronic device 500C of a portion of the electronic device 500C of FIG. 7 in accordance with some embodiments of the disclosure. FIG. 7 is also a schematic cross-sectional view taken along the line B-B' along the peripheral edge region (the first region R1) of a semiconductor die 400C. FIGS. 8 and 9 illustrate the arrangement of the bumps on the top and bottom surfaces 400TS, 400BS and close to the peripheral edge 400E of the semiconductor die 400C. Elements of the embodiments hereinafter, that are the same or similar as those previously described with reference to FIGS. 1 to 6, are not repeated for brevity.

As shown in FIGS. 1-3 and 7-9, the difference between the electronic device 500A and the electronic device 500C at least includes that the semiconductor die 400C of the electronic device 500C further includes a first functional cell C1'. In addition, the semiconductor die 400C further includes signal bumps BS1-1', power bump BP1-1' and ground bumps BG 1-1', BG 1-2' electrically connected to first functional cell C1'.

The first functional cell C1' is formed on the back-side surface 200B of the semiconductor substrate 200 and covered by the back-side interconnect structure 220. In some embodiments, the first functional cell C1 and the first functional cell C1' are formed on opposite surfaces of the semiconductor die 200 in the first region R1.

In some embodiments, the signal bumps BS1-1' and the ground bumps BG1-1' are disposed on the outermost layer of the back-side interconnect structure 220. In other words, the signal bumps BS1-1' and the ground bumps BG 1-1' are disposed on the bottom surface 400BS of the semiconductor die 400A. The signal bump BS1-1' is electrically connected to a signal routing 240S1'of the back-side interconnect structure 220. The ground bump BG1-1' is electrically connected to the ground routing (not shown) of the back-side interconnect structure 220. The signal bumps BS1-1' and the ground bumps BG1-1' are electrically connected to corresponding bump pads (not shown) of the back-side interconnect structure 220

In some embodiments, the power bumps BP1-1' and the ground bumps BG1-2' are disposed on the outermost layer of the front-side interconnect structure 210. In other words, the power bumps BP1-1' and the ground bumps BG1-2' are disposed on the top surface 400TS of the semiconductor die 400A. The power bump BP1-1' is electrically connected to the first functional cell C1' by a power routing 230P1' of the front-side interconnect structure 210 and a through-substrate via TSV-P1'. The ground bump BG1-2' is electrically connected to the first functional cell C1' by a ground routing 230G2' of the front-side interconnect structure 210 and a through-substrate via TSV-G1'. The power bumps BP1-1' and the ground bumps BG1-2' are electrically connected to corresponding bump pads (not shown) of the front-side interconnect structure 210.

In some embodiments, the signal bumps BS1-1' are separated from the power bumps BP1-1' and the ground bumps BG1-2' by the semiconductor substrate 200, the front-side interconnect structure 210 and the back-side interconnect structure 220. In addition, the ground bumps BG1-1' are separated from the power bumps BP1-1' and the ground bumps BG1-2' by the semiconductor substrate 200, the front-side interconnect structure 210 and the back-side interconnect structure 220.

In some embodiments, the signal bumps BS1-1' and the ground bumps BG 1-1' on the back-side interconnect structure 220 may arranged as a bump array BA1-1' having a single row or multi rows. The bump array BA1-1' may at least overlap the first region R1. The arrangements and the bump pitch of the signal bumps BS1-1' and the ground bumps BG1-1' of the bump array BA1-1' may be the same or similar to the arrangements and the bump pitch of the signal bumps BS1-1 and the ground bumps BG1-1 of the bump array BA1-1, and not repeated for brevity.

In some embodiments, the power bumps BP1-1' and the ground bumps BG1-2' on the front-side interconnect structure 210 may arranged as a bump array BA1-2' overlapping the first region R1. The arrangements and the bump pitch of the power bumps BP1-1' and the ground bumps BG1-2' of the bump array BA1-2' may be the same or similar to the arrangements and the bump pitch of the power bumps BP1-1 and the ground bumps BG1-2 of the bump array BA1-2, and not repeated for brevity.

In the first region R1, the power bumps BP1-1' and some of the signal bumps BS1-1' disposed on opposite surfaces of the semiconductor substrate 200. The ground bumps BG1-2' and some of the signal bumps BS1-1' disposed on opposite surfaces of the semiconductor substrate 200. More specifically, the power bumps BP1-1' are disposed on the front surface 200F of the semiconductor substrate 200. Some of the signal bumps BS1-1' are disposed on the back surface 200B of the semiconductor substrate 200. In addition, the ground bumps BG1-2' are disposed on the front surface 200F of the semiconductor substrate 200.

In this embodiment, the signal bump BS1-1 and the signal bump BS1-1' are disposed on opposite surfaces of the semiconductor substrate 200. The power bumps BP1-1 and the signal bump BP1-1' are disposed on opposite surfaces of the semiconductor substrate 200. The ground bumps BG1-1 and the ground bumps BG1-1' are disposed on opposite surfaces of the semiconductor substrate 200. The signal bump BS1-1' and the power bumps BP2-1 are disposed on opposite surfaces of the semiconductor substrate 200.

In this embodiment, the signal bump BS1-1, the ground bumps BG1-1, the power bumps BP1-1' and the ground bumps BG1-2' are disposed on the same surface (the front surface 200F) of the semiconductor substrate 200.

In other words, the first functional cell C1' and the corresponding bump arrays BA1-1' and BA1-2' on the back surface 200B of the semiconductor substrate 200 may be vertically inverted (upside down) respectively relative to the first functional cell C1 and the corresponding bump arrays BA1-1 and BA1-2 on the front surface 200F of the semiconductor substrate 200.

The semiconductor die 400C may further include a third functional cell C3 (I/O cross line cell) laterally (along a direction that is substantially parallel to the front surface 200F (or the back surface 200B) of the semiconductor substrate 200) interposed between the first functional cell C1 and the first functional cell C1'. In some embodiments, the third functional cell C3 is adjacent to the first functional cell C1 and the first functional cell C1'. The power bumps BP1-1 are electrically connected to the power bumps BP1-1' by the third functional cell C3.

In some embodiments, the third functional cell C3 includes conductive paths 250 composed of power routings (not shown) formed in the front-side interconnect structure 210 and the back-side interconnect structure 220 and through-substrate vias (not shown) passing through the semiconductor substrate 200. The conductive paths 250 may electrically connected to the power routings 240P1 and 240P1'.

In some embodiments, the conductive paths 250 in the third functional cell C3 may further composed of ground routings (not shown) formed in the front-side interconnect structure 210 and the back-side interconnect structure 220 and through-substrate vias (not shown) passing through the semiconductor substrate 200. The conductive paths 250 may electrically connected to the ground routings (not shown) in the first functional cell C1 and the first functional cell C1. When the first functional cells C1 and C1' are I/O cells, the third functional cell C3 is also called an I/O cross line cell C3.

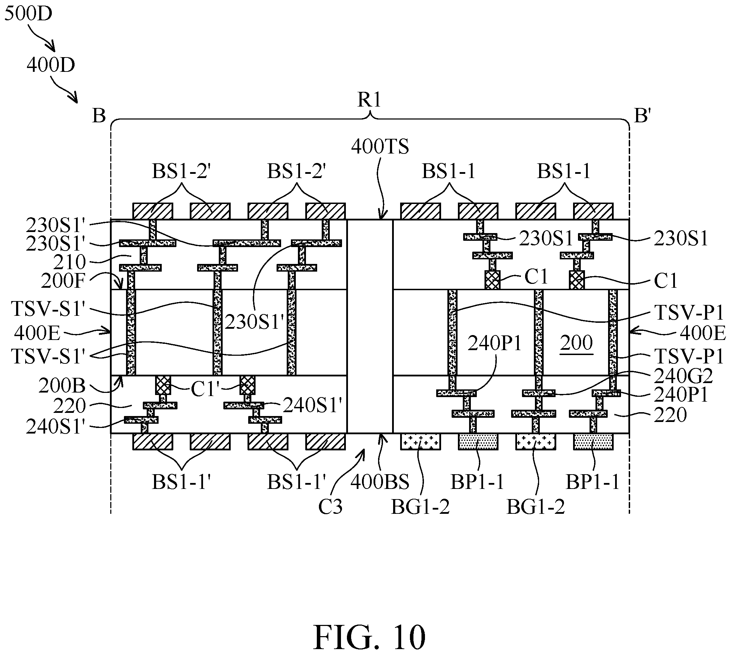

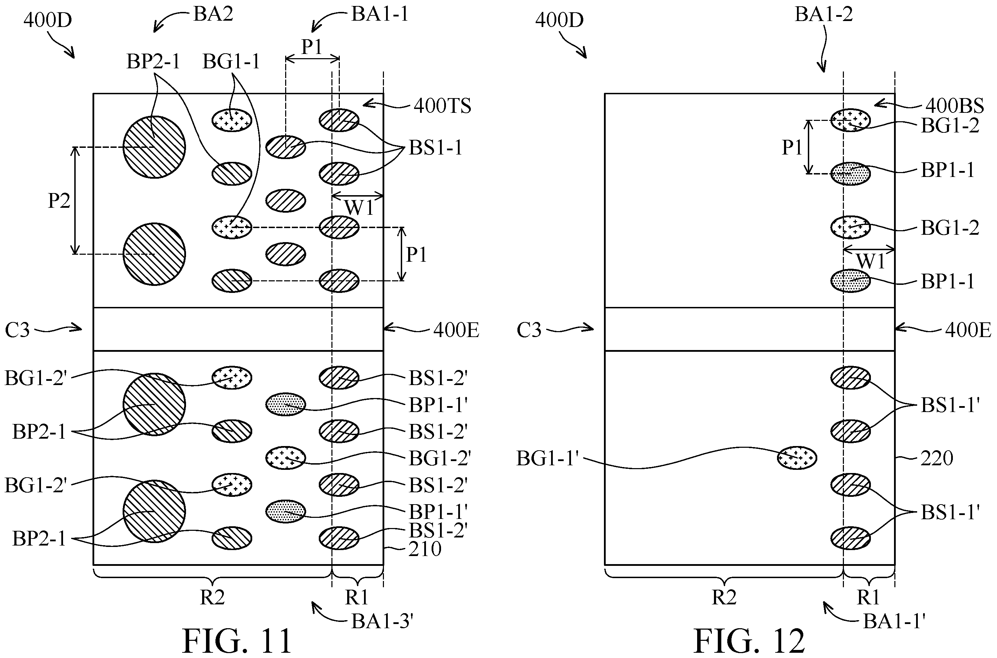

FIG. 10 is a schematic cross-sectional view of an electronic device 500D in accordance with some embodiments of the disclosure. FIG. 11 is an enlarged top view of a portion of the electronic device 500D of FIG. 10 in accordance with some embodiments of the disclosure. FIG. 12 is an enlarged bottom view of a portion of the electronic device 500D of FIG. 10 in accordance with some embodiments of the disclosure. FIGS. 10 and 11 also illustrate the arrangement of the bumps on the top and bottom surfaces 400TS, 400BS and close to the peripheral edge 400E of a semiconductor die 400D. Elements of the embodiments hereinafter, that are the same or similar as those previously described with reference to FIGS. 1 to 9, are not repeated for brevity.

As shown in FIGS. 7-12, the difference between the electronic device 500C and the electronic device 500D at least includes that the semiconductor die 400D of the electronic device 500D further includes signal bumps BS1-2' and signal routings 230S1' arranged on the front surface 200F of the semiconductor substrate 200. In addition, the signal bumps BS1-2' are electrically connected to the first functional cell C1' by the signal routings 230S1' and through-substrate via TSV-S1'.

In this embodiment, the signal bump BS1-2', the power bumps BP1-1 and the ground bumps BG1-2' on the front-side interconnect structure 210 may arranged as a bump array BA1-3' at least overlapping the first region R1. The arrangements and the bump pitch of the signal bumps BS1-2', the power bumps BP1-1 and the ground bumps BG1-2' of the bump array BA 1-3' may be the same or similar to the arrangements and the bump pitch of the signal bumps BS1-2, the power bumps BP1-1 and the ground bumps BG1-2 of the bump array BA1-3, and not repeated for brevity.

In this embodiment, the power bumps BP1-1, the ground bumps BG1-1, the signal bumps BS1-2', the power bumps BP1-1' and the ground bumps BG1-2' are disposed on the same surface (the front surface 200F) of the semiconductor substrate 200.

In other words, the first functional cell C1' and the corresponding bump arrays BA1-1' and BA1-3' on the back surface 200B of the semiconductor substrate 200 may be vertically inverted (upside down) respectively relative to the first functional cell C1 and the corresponding bump arrays BA1-1 and BA1-3 on the front surface 200F of the semiconductor substrate 200.

Embodiments provide an electronic device. The electronic device includes a semiconductor die. The semiconductor die has a first region of a first functional cell close to a peripheral edge of the semiconductor die. The semiconductor die includes a semiconductor substrate, a first signal bump and a first power bump. The first signal bump and the first power bump are disposed on opposite surfaces of the semiconductor substrate and electrically connected to the first functional cell. The first signal bump and the first power bump both overlap the first region.

In some embodiments, the semiconductor die further includes a front-side interconnect structure and a back-side interconnect structure. The front-side interconnect structure is disposed on a front-side surface of the semiconductor substrate. The back-side interconnect structure is disposed on a back-side surface of the semiconductor substrate. The first signal bump is separated from the first power bump by the semiconductor substrate, the front-side interconnect structure and the back-side interconnect structure.

In some embodiments, the back-side interconnect structure disposed on a back-side surface of the semiconductor substrate, wherein the first signal bump is separated from the first power bump by the semiconductor substrate, the front-side interconnect structure and the back-side interconnect structure. The first signal bump is disposed on the front-side interconnect structure and electrically connected to a first signal routing of the front-side interconnect structure. The first power bump disposed on the back-side interconnect structure and electrically connected to a first power routing of the back-side interconnect structure.

In some embodiments, the first functional cell is formed on the back-side surface of the semiconductor substrate and covered by the back-side interconnect structure. The first power bump is disposed on the front-side interconnect structure and electrically connected to a first power routing of the front-side interconnect structure. The first signal bump disposed on the back-side interconnect structure and electrically connected to a first signal routing of the back-side interconnect structure.

In some embodiments, the semiconductor die further includes a second signal bump overlapping the first region and electrically connected to the first functional cell, wherein the first signal bump and the second signal bump are disposed on opposite surfaces of the semiconductor substrate.

In some embodiments, the semiconductor die further includes a first ground bump electrically connected to the first functional cell, wherein the first signal bump and the first ground bump are disposed on opposite surfaces of the semiconductor substrate.

In some embodiments, the first ground bump overlaps the first region.

In some embodiments, the first ground bump overlaps the second region.

In some embodiments, the semiconductor die has a second region of a second functional cell arranged corresponding to a central portion of the semiconductor die. The semiconductor die further includes a third power bump overlapping the second region and electrically connected to the second functional cell, wherein the third power bump is disposed on the front-side interconnect structure.

In some embodiments, the first power bump and the third power bump are disposed on opposite surfaces of the semiconductor substrate.

In some embodiments, the first signal bump and the third power bump are disposed on opposite surfaces of the semiconductor substrate.

In some embodiments, the first functional cell includes an input/output cell, and the second functional cell includes a center power cell.

In some embodiments, the semiconductor die comprises another first functional cell disposed in the first region. The semiconductor die further includes a third signal bump and a fourth power bump disposed on opposite surfaces of the semiconductor substrate and electrically connected to the other first functional cell. The fourth signal bump and the fourth power bump both overlap the first region.

In some embodiments, the other first functional cell is formed on the back-side surface of the semiconductor substrate and covered by the back-side interconnect structure. The fourth power bump is disposed on and electrically connected to the front-side interconnect structure. The third signal bump is disposed on and electrically connected to the back-side interconnect structure.

In some embodiments, the first signal bump and the third signal bump are disposed on opposite surfaces of the semiconductor substrate.

In some embodiments, the semiconductor die further includes a third ground bump electrically connected to the other first functional cell. The fourth power bump and the third ground bump are disposed on the same surface of the semiconductor substrate.

In some embodiments, the semiconductor die further includes a third functional cell laterally interposed between the first functional cell and the other first functional cell, wherein the first power bump is electrically connected to the third power bump by the third functional cell.

Embodiments also provide an electronic device. The electronic device includes a semiconductor die. The semiconductor die has a peripheral edge region. The semiconductor die includes a first functional cell, a first-side interconnect structure and a second-side interconnect structure. The first-side interconnect structure is disposed above the first functional cell. The second-side interconnect structure is disposed below the first functional cell. The peripheral edge region includes a first signal bump and a first power bump. The first signal bump is disposed on the first-side interconnect structure and electrically connected to the first functional cell. The first power bump is disposed on the second-side interconnect structure and electrically connected to the first functional cell.

In some embodiments, the peripheral edge region further includes a first ground bump disposed on the second-side interconnect structure and electrically connected to the first functional cell.

In some embodiments, the semiconductor die has a central region. The semiconductor die further includes a second functional cell disposed in the central region. The front-side interconnect structure is disposed above the second functional cell. The central region includes a second power bump disposed on the first-side interconnect structure and electrically connected to the second functional cell.

In some embodiments, the first functional cell includes an input/output cell, and the second functional cell includes a center power cell.

In some embodiments, the semiconductor die further includes another first functional cell and a third functional cell. The other first functional cell is disposed in the peripheral edge region. The peripheral edge region further includes a third signal bump disposed on the second-side interconnect structure and electrically connected to the other first functional cell. The third functional cell is laterally interposed between the first functional cell and the other first functional cell, wherein the first power bump is electrically connected to the third power bump by the third functional cell.

In the electronic device, the semiconductor die is fabricated using back-side power technology to decrease front-side routing. The power bumps (e.g. the I/O power bumps) electrically connected to the first functional cell (e.g. the I/O cell) arranged in the peripheral edge region may move onto the back surface of the semiconductor substrate accordingly. The electronic device may further moves signal bumps electrically connected to the first functional cell onto the back surface of the semiconductor substrate. The bumps array for the first functional cell may have reduced number of rows. The conductive routings of the first functional cell in the front-side interconnect structure can be reduced, thereby improving IR drop issue of the front-side interconnect structure.

In addition, the area of the front-side interconnect structure in the central region originally occupied by the bumps electrically connected to the first functional cell may be released for putting more power bumps for the second functional cell (e.g. the center power cell). The bump array (the center power bump array) may have more rows. The performance of the second functional cell can be improved.

Furthermore, the electronic device may include another first functional cell and the corresponding bump arrays on the back surface of the semiconductor substrate may be vertically inverted (upside down) respectively relative to the first functional cell and the corresponding bump arrays on the front surface of the semiconductor substrate. The power and ground routings of first functional cells on the opposite surface of the semiconductor substrate may be electrically connected to each other by a third functional cell including power and ground routings and through-substrate vias.

While the invention has been described by way of example and in terms of the preferred embodiments, it should be understood that the invention is not limited to the disclosed embodiments. On the contrary, it is intended to cover various modifications and similar arrangements (as would be apparent to those skilled in the art). Therefore, the scope of the appended claims should be accorded the broadest interpretation so as to encompass all such modifications and similar arrangements.

The present invention may also be defined by the following numbered clauses.
1. An electronic device, comprising:
   a semiconductor die having a first region of a first functional cell close to a peripheral edge of the semiconductor
      die, wherein the semiconductor die comprises:
      a semiconductor substrate; and
      a first signal bump and a first power bump disposed on opposite surfaces of the semiconductor substrate and electrically connected to the first functional cell, wherein the first signal bump and the first power bump both overlap the first region.
2. The electronic device of clause 1, wherein the semiconductor die further comprises:
   a front-side interconnect structure disposed on a front-side surface of the semiconductor substrate; and
   a back-side interconnect structure disposed on a back-side surface of the semiconductor substrate, wherein the first signal bump is separated from the first power bump by the semiconductor substrate, the front-side interconnect structure and the back-side interconnect structure.
3. The electronic device of clause 2, wherein:
   the first functional cell is formed on the front-side surface of the semiconductor substrate and covered by the front-side interconnect structure,
   the first signal bump is disposed on the front-side interconnect structure and electrically connected to a first signal routing of the front-side interconnect structure, and
   the first power bump disposed on the back-side interconnect structure and electrically connected to a first power routing of the back-side interconnect structure.
4. The electronic device of clause 2, wherein:
   the first functional cell is formed on the back-side surface of the semiconductor substrate and covered by the back-side interconnect structure,
   the first power bump is disposed on the front-side interconnect structure and electrically connected to a first power routing of the front-side interconnect structure, and
   the first signal bump disposed on the back-side interconnect structure and electrically connected to a first signal routing of the back-side interconnect structure.
5. The electronic device of clause 1, wherein the semiconductor die further comprises:
   a second signal bump overlapping the first region and electrically connected to the first functional cell, wherein the first signal bump and the second signal bump are disposed on opposite surfaces of the semiconductor substrate.
6. The electronic device of clause 1, wherein the semiconductor die further comprises:
   a first ground bump electrically connected to the first functional cell, wherein the first signal bump and the first ground bump are disposed on opposite surfaces of the semiconductor substrate.
7. The electronic device of clause 6, wherein the first ground bump overlaps the first region.
8. The electronic device of clause 6, wherein the first ground bump overlaps the second region.
9. The electronic device of clause 2, wherein the semiconductor die has a second region of a second functional cell arranged corresponding to a central portion of the semiconductor die, wherein the semiconductor die further comprises:
   a third power bump overlapping the second region and electrically connected to the second functional cell, wherein the third power bump is disposed on the front-side interconnect structure.
10. The electronic device of clause 9, wherein the first power bump and the third power bump are disposed on opposite surfaces of the semiconductor substrate.
11. The electronic device of clause 9, wherein the first signal bump and the third power bump are disposed on opposite surfaces of the semiconductor substrate.
12. The electronic device of clause 9, wherein the first functional cell comprises an input/output cell, and the second functional cell comprises a center power cell.
13. The electronic device of clause 3, wherein the semiconductor die comprises another first functional cell disposed in the first region, and the semiconductor die further comprises:
   a third signal bump and a fourth power bump disposed on opposite surfaces of the semiconductor substrate and electrically connected to the other first functional cell, wherein the fourth signal bump and the fourth power bump both overlap the first region.
14. The electronic device of clause 13, wherein:
   the other first functional cell is formed on the back-side surface of the semiconductor substrate and covered by the back-side interconnect structure,
   the fourth power bump is disposed on and electrically connected to the front-side interconnect structure, and
   the third signal bump is disposed on and electrically connected to the back-side interconnect structure.
15. The electronic device of clause 13, wherein the first signal bump and the third signal bump are disposed on opposite surfaces of the semiconductor substrate.
16. The electronic device of clause 13, wherein the semiconductor die further comprises:
   a third ground bump electrically connected to the other first functional cell, wherein the fourth power bump and the third ground bump are disposed on the same surface of the semiconductor substrate.
17. The electronic device of clause 13, wherein the semiconductor die further comprises:
   a third functional cell laterally interposed between the first functional cell and the other first functional cell, wherein the first power bump is electrically connected to the third power bump by the third functional cell.
18. An electronic device, comprising:
   a semiconductor die having a peripheral edge region, wherein the semiconductor die comprises:
      a first functional cell disposed in the peripheral edge region;
      a first-side interconnect structure disposed above the first functional cell; and
      a second-side interconnect structure disposed below the first functional cell,
   wherein the peripheral edge region comprises:
      a first signal bump disposed on the first-side interconnect structure and electrically connected to the first functional cell; and
      a first power bump disposed on the second-side interconnect structure and electrically connected to the first functional cell.
19. The electronic device of clause 18, wherein the peripheral edge region further comprises:
   a first ground bump disposed on the second-side interconnect structure and electrically connected to the first functional cell.
20. The electronic device of clause 18, wherein the semiconductor die has a central region, and the semiconductor die further comprises:
   a second functional cell disposed in the central region, wherein the front-side interconnect structure is disposed above the second functional cell, and
   wherein the central region comprises:
      a second power bump disposed on the first-side interconnect structure and electrically connected to the second functional cell.
21. The electronic device of clause 20, wherein the first functional cell comprises an input/output cell, and the second functional cell comprises a center power cell.
22. The electronic device of clause 18, wherein the semiconductor die further comprises:
   another first functional cell disposed in the peripheral edge region, and
   wherein the peripheral edge region further comprises:
      a third signal bump disposed on the second-side interconnect structure and electrically connected to the other first functional cell; and
      a fourth power bump disposed on the first-side interconnect structure and electrically connected to the other first functional cell; and
   a third functional cell laterally interposed between the first functional cell and the other first functional cell, wherein the first power bump is electrically connected to the third power bump by the third functional cell.

## Claims

1. An electronic device (500A, 500B, 500C, 500D), comprising:
a semiconductor die (400A, 400B, 400C, 400D) having a first region (R1) of a first functional cell (C1) close to a peripheral edge (400E) of the semiconductor die (400A, 400B, 400C, 400D), wherein the semiconductor die (400A, 400B, 400C, 400D) comprises:
a semiconductor substrate (200); and
a first signal bump (BS1-1, BS1-1') and a first power bump (BP1-1, BP1-1') disposed on opposite surfaces of the semiconductor substrate (200) and electrically connected to the first functional cell (C1), wherein the first signal bump (BS1-1, BS1-1') and the first power bump (BP1-1, BP1-1') both overlap the first region (R1).

2. The electronic device (500A, 500B, 500C, 500D) as claimed in claim 1, wherein the semiconductor die (400A, 400B, 400C, 400D) further comprises:
a front-side interconnect structure (210, 260) disposed on a front-side surface of the semiconductor substrate (200); and
a back-side interconnect structure (220) disposed on a back-side surface of the semiconductor substrate (200), wherein the first signal bump (BS1-1, BS1-1') is separated from the first power bump (BP1-1, BP1-1') by the semiconductor substrate (200), the front-side interconnect structure (210, 260) and the back-side interconnect structure (220).

3. The electronic device (500A, 500B, 500C, 500D) as claimed in claim 2, wherein:
the first functional cell (C1) is formed on the front-side surface of the semiconductor substrate (200) and covered by the front-side interconnect structure (210, 260),
the first signal bump (BS1-1, BS1-1') is disposed on the front-side interconnect structure (210, 260) and electrically connected to a first signal routing (240S1) of the front-side interconnect structure (210, 260), and
the first power bump (BP1-1, BP1-1') disposed on the back-side interconnect structure (220) and electrically connected to a first power routing (230P1', 240P1, 240P1') of the back-side interconnect structure (220); or
wherein:
the first functional cell (C1) is formed on the back-side surface of the semiconductor substrate (200) and covered by the back-side interconnect structure (220),
the first power bump (BP1-1, BP1-1') is disposed on the front-side interconnect structure (210, 260) and electrically connected to a first power routing (230P1', 240P1, 240P1') of the front-side interconnect structure (210, 260), and
the first signal bump (BS1-1, BS1-1') disposed on the back-side interconnect structure (220) and electrically connected to a first signal routing (240S1) of the back-side interconnect structure (220).

4. The electronic device (500A, 500B, 500C, 500D) as claimed in claim 1, wherein the semiconductor die (400A, 400B, 400C, 400D) further comprises:
a second signal bump (BS1-2, BS1-2') overlapping the first region (R1) and electrically connected to the first functional cell (C1), wherein the first signal bump (BS1-1, BS1-1') and the second signal bump (BS1-2, BS1-2') are disposed on opposite surfaces of the semiconductor substrate (200); or
wherein the semiconductor die (400A, 400B, 400C, 400D) further comprises:
a first ground bump (BG1-1) electrically connected to the first functional cell (C1), wherein the first signal bump (BS1-1, BS1-1') and the first ground bump are disposed on opposite surfaces of the semiconductor substrate (200).

5. The electronic device (500A, 500B, 500C, 500D) as claimed in claim 4, wherein the first ground bump (BG1-1, BG1-2) overlaps the first region (R1); or
wherein the first ground bump (BG1-1, BG1-2) overlaps the second region (R2).

6. The electronic device (500A, 500B, 500C, 500D) as claimed in claim 2, wherein the semiconductor die (400A, 400B, 400C, 400D) has a second region (R2) of a second functional cell (C2) arranged corresponding to a central portion (270a, 270b) of the semiconductor die (400A, 400B, 400C, 400D), wherein the semiconductor die (400A, 400B, 400C, 400D) further comprises:
a third power bump overlapping the second region (R2) and electrically connected to the second functional cell (C2), wherein the third power bump is disposed on the front-side interconnect structure (210, 260).

7. The electronic device (500A, 500B, 500C, 500D) as claimed in claim 6, wherein the first power bump and the third power bump are disposed on opposite surfaces of the semiconductor substrate (200); or wherein the first signal bump (BS1-1, BS1-1') and the third power bump are disposed on opposite surfaces of the semiconductor substrate (200); or
wherein the first functional cell (C1) comprises an input/output cell, and the second functional cell (C2) comprises a center power cell.

8. The electronic device (500A, 500B, 500C, 500D) as claimed in claim 3, wherein the semiconductor die (400A, 400B, 400C, 400D) comprises another first functional cell (C1) disposed in the first region (R1), and the semiconductor die (400A, 400B, 400C, 400D) further comprises:
a third signal bump and a fourth power bump disposed on opposite surfaces of the semiconductor substrate (200) and electrically connected to the other first functional cell (C1), wherein the fourth signal bump and the fourth power bump both overlap the first region (R1).

9. The electronic device (500A, 500B, 500C, 500D) as claimed in claim 8, wherein:
the other first functional cell (C1) is formed on the back-side surface of the semiconductor substrate (200) and covered by the back-side interconnect structure (220),
the fourth power bump is disposed on and electrically connected to the front-side interconnect structure (210, 260), and
the third signal bump is disposed on and electrically connected to the back-side interconnect structure (220); or
wherein the first signal bump (BS1-1, BS1-1') and the third signal bump are disposed on opposite surfaces of the semiconductor substrate (200).

10. The electronic device (500A, 500B, 500C, 500D) as claimed in claim 8, wherein the semiconductor die (400A, 400B, 400C, 400D) further comprises:
a third ground bump (BG1-1, BG 1-2) electrically connected to the other first functional cell (C1), wherein the fourth power bump and the third ground bump (BG1-1, BG1-2) are disposed on the same surface of the semiconductor substrate (200); or.
wherein the semiconductor die (400A, 400B, 400C, 400D) further comprises:
a third functional cell (C3) laterally interposed between the first functional cell (C1) and the other first functional cell (C1), wherein the first power bump is electrically connected to the third power bump by the third functional cell (C3).

11. An electronic device (500A, 500B, 500C, 500D), comprising:
a semiconductor die (400A, 400B, 400C, 400D) having a peripheral edge (400e) region, wherein the semiconductor die (400A, 400B, 400C, 400D) comprises:
a first functional cell (C1) disposed in the peripheral edge (400E) region;
a first-side interconnect structure disposed above the first functional cell (C1); and
a second-side interconnect structure disposed below the first functional cell (C1),
wherein the peripheral edge (400E) region comprises:
a first signal bump (BS1-1, BS1-1') disposed on the first-side interconnect structure and electrically connected to the first functional cell (C1); and
a first power bump (BP1-1, BP1-1') disposed on the second-side interconnect structure and electrically connected to the first functional cell (C1).

12. The electronic device (500A, 500B, 500C, 500D) as claimed in claim 11, wherein the peripheral edge (400E) region further comprises:
a first ground bump (BG1-1, BG1-2) disposed on the second-side interconnect structure and electrically connected to the first functional cell (C1).

13. The electronic device (500A, 500B, 500C, 500D) as claimed in claim 11, wherein the semiconductor die (400A, 400B, 400C, 400D) has a central region, and the semiconductor die (400A, 400B, 400C, 400D) further comprises:
a second functional cell (C2) disposed in the central region, wherein the front-side interconnect structure (210, 260) is disposed above the second functional cell (C2), and
wherein the central region comprises:
a second power bump (BP2-1) disposed on the first-side interconnect structure and electrically connected to the second functional cell (C2).

14. The electronic device (500A, 500B, 500C, 500D) as claimed in claim 13, wherein the first functional cell (C1) comprises an input/output cell, and the second functional cell (C2) comprises a center power cell.

15. The electronic device (500A, 500B, 500C, 500D) as claimed in claim 11, wherein the semiconductor die (400A, 400B, 400C, 400D) further comprises:
another first functional cell (C1) disposed in the peripheral edge (400E) region, and
wherein the peripheral edge (400E) region further comprises:
a third signal bump disposed on the second-side interconnect structure and electrically connected to the other first functional cell (C1); and
a fourth power bump disposed on the first-side interconnect structure and electrically connected to the other first functional cell (C1); and
a third functional cell (C3) laterally interposed between the first functional cell (C1) and the other first functional cell (C1), wherein the first power bump is electrically connected to the third power bump by the third functional cell (C3).
